# EUROPÄISCHE PATENTSCHRIFT

(11) **EP 1 256 134 B1**
(45) Veröffentlichungstag und Bekanntmachung des Hinweises auf die Patenterteilung: **27.05.2015**
(21) Anmeldenummer: 00988672.2
(22) Anmeldetag: 30.11.2000
(51) Int. Cl.: H01L 33/00, H01L 33/20, H01L 33/38, H01L 33/40, H01L 33/22, H01L 33/60

(54) **STRAHLUNGSEMITTIERENDES HALBLEITERBAUELEMENT, VERFAHREN ZU SEINER HERSTELLUNG UND STRAHLUNGSEMITTIERENDES OPTISCHES BAUELEMENT**
RADIATION-EMITTING SEMICONDUCTOR ELEMENT, METHOD FOR PRODUCTION THEREOF AND RADIATION EMITTING OPTICAL COMPONENT
COMPOSANT A SEMICONDUCTEURS EMETTANT UN RAYONNEMENT, SON PROCEDE DE PRODUCTION ET COMPOSANT OPTIQUE EMETTANT UN RAYONNEMENT

(30) Priorität: 15.02.2000 DE 10006738
(43) Veröffentlichungstag der Anmeldung: 13.11.2002
(73) Patentinhaber: OSRAM Opto Semiconductors GmbH, 93055 Regensburg (DE)
(72) Erfinder: EISERT, Dominik, 93049 Regensburg (DE); HÄRLE, Volker, 93164 Laaber (DE); KÜHN, Frank, 81739 München (DE); MUNDBROD, Manfred, 93049 Regensburg (DE); STRAUSS, Uwe, 93077 Bad Abbach (DE); ZEHNDER, Ulrich, 93049 Regensburg (DE)
(74) Vertreter: Epping - Hermann - Fischer
(86) Internationale Anmeldenummer: PCT/DE2000/004269
(87) Internationale Veröffentlichungsnummer: WO 2001/061764

(56) Entgegenhaltungen:
- EP-A- 0 405 757
- EP-A- 0 562 880
- EP-A- 0 779 667
- DE-A- 4 130 878
- DE-A- 4 427 840
- US-A- 4 965 223
- US-A- 5 779 924
- PATENT ABSTRACTS OF JAPAN vol. 008, no. 084 (E-239), 18. April 1984 (1984-04-18) & JP 59 004088 A (TOKYO SHIBAURA DENKI), 10. Januar 1984 (1984-01-10)
- PATENT ABSTRACTS OF JAPAN vol. 1995, no. 06, 31. Juli 1995 (1995-07-31) -& JP 07 086635 A (DAIDO STEEL CO), 31. März 1995 (1995-03-31)
- PATENT ABSTRACTS OF JAPAN vol. 016, no. 108 (E-1179), 17. März 1992 (1992-03-17) & JP 03 283675 A (TOSHIBA CORP), 13. Dezember 1991 (1991-12-13)
- PATENT ABSTRACTS OF JAPAN vol. 018, no. 144 (E-1521), 10. März 1994 (1994-03-10) & JP 05 327012 A (SANYO ELECTRIC CO), 10. Dezember 1993 (1993-12-10)
- PATENT ABSTRACTS OF JAPAN vol. 1996, no. 08, 30. August 1996 (1996-08-30) & JP 08 102549 A (ROHM CO LTD), 16. April 1996 (1996-04-16)

## Beschreibung

Die Erfindung betrifft ein strahlungsemittierendes Halbleiterbauelement, bei dem einer Mehrschichtstruktur mit einer strahlungserzeugenden aktiven Zone eine Fensterschicht zur Auskopplung von Strahlung zugeordnet ist.

Sie bezieht sich im Besonderen auf ein strahlungsemittierendes Halbleiterelement mit einer auf einem SiC-basierten Aufwachssubstrat aufgebrachten Nitrid-basierten aktiven Mehrschichtstruktur und auf ein mit einem solchen strahlungsemittierenden Halbleiterelement ausgestatteten strahlungsemittierenden optischen Bauelement.

Die Erfindung betrifft weiter ein Verfahren zum Herstellen des strahlungsemittierenden Halbleiterelements sowie eines optischen Bauelements mit einem derartigen Halbleiterkörper.

Typischerweise werden für strahlungsemittierende optische Bauelemente, insbesondere für Lumineszenzdioden-Bauelemente, derzeit im Wesentlichen ausschließlich quaderförmige strahlungsemittierende Halbleiterelemente eingesetzt, die in der Regel in transparentes Vergußmaterial eingebettet sind. Eine große Schwierigkeit bereitet hierbei der große Unterschied der Brechungsindices von üblichen Halbleitermaterialien optischer Halbleiterelemente (n > 2,5) und den herkömmlich zur Verfügung stehenden Vergußmaterialien (zum Beispiel Epoxidharz; n_{Epoxy} ≅ 1,5). Der Grenzwinkel der Totalreflexion an der Grenzfläche zwischen Halbleiterkörper und Vergußmaterial ist folglich sehr klein. Dies ist Ursache dafür, daß aufgrund von Totalreflexion an den Chipoberflächen ein erheblicher Teil des in der aktiven Zone erzeugten Lichts nicht aus dem Halbleiterkörper ausgekoppelt wird und in dessen Innerem verloren geht. Bei vorgegebenem elektrischen Strom, der das Halbleiter-Bauelement zur Erzeugung des Lichts durchfließt, ist damit die Helligkeit des Bauelements begrenzt.

Bei GaN-basierten Leuchtdiodenchips, bei denen die Epitaxieschichtenfolge auf einem Substrat (beispielsweise einem Siliziumcarbid-Substrat) angeordnet ist, das einen höheren Brechungsindex aufweist als die Epitaxieschichtenfolge, tritt zudem das besondere Problem auf, dass bei herkömmlicher quaderartiger Chipgeometrie der durch die Substratflanken ausgekoppelte Strahlunganteil in einem sehr spitzen Winkel zur Substratflanke in Richtung Chiprückseite ausgekoppelt wird. Diese Strahlung trifft somit in einem sehr steilen Winkel und sehr nah am Chip auf eine Gehäusemontagefläche, auf der der Chip befestigt ist. Dies zieht die Nachteile nach sich, dass erstens aufgrund des spitzen Einfallswinkels ein großer Teil der Strahlung in der Chipmontagefläche absorbiert wird und zweitens eine erhebliche Gefahr besteht, dass ein gewisser Teil der Strahlung auf den zur Befestigung des Chips üblicherweise verwendeten Leitkleber trifft und von diesem absorbiert wird.

In der DE 198 07 758 A1 ist ein strahlungsemittierender Halbleiterkörper vorgeschlagen, bei dem zur Lichtausbeute-Erhöhung der aktiven Zone in der vorgesehenen Abstrahlrichtung des Halbleiterkörpers eine sogenannte primäre Fensterschicht nachgeordnet ist, deren durchgehende Seitenoberfläche mit der Erstreckungsebene der mehrschichtigen Heterostruktur einen stumpfen Winkel einschließt. Die durchgehende Seitenoberfläche schließt mit der Ebene der aktiven Zone einen stumpfen Winkel zwischen 110° und 140° ein. Die primäre Fensterschicht ist hierbei von dem Aufwachssubstrat oder von einer auf diesem gesondert aufgewachsenen epitaxialen Schicht gebildet.

Zusätzlich kann der Halbleiterkörper gemäß DE 198 07 758 A1 eine weitere, sogenannte sekundäre Fensterschicht aufweisen, die an der von der primären Fensterschicht abgewandten Seite der aktiven Zone, das heißt an der Unterseite des Halbleiterkörpers, mittels Epitaxie oder Waferbonden aufgebracht ist und deren durchgehende Seitenoberfläche mit der Ebene der aktiven Zone einen Winkel zwischen 40° und 70° einschließt. Der Halbleiterkörper weist folglich von der Oberseite zur Unterseite durchgehend schräg stehende Chipflanken auf.

Diese Chipgeometrie dient in erster Linie dazu, die parallel zur aktiven Zone verlaufende Oberfläche des Chips größer als die aktive Zone zu machen und zu erreichen, daß Licht, das auf die schräg stehenden Seitenwände des primären Fensters auftrifft, zur vorgesehenen Abstrahlrichtung hin vollständig intern zu reflektieren.

Die sekundäre Fensterschicht erfüllt zusätzlich die Aufgabe, von der aktiven Zone nach hinten, das heißt in Richtung Montagefläche des Halbleiterkörpers ausgesandtes Licht über die schräg stehenden Seitenflächen der sekundären Fensterschicht aus dem Halbleiterkörper auszukoppeln.

Um eine Auskopplung von Licht in Rückwärtsrichtung zu vermindern und dieses Licht vorzugsweise bereits im Halbleiterkörper zur Vorderseite hin umzulenken, ist eine reflektierende Beschichtung der gesamten schräg stehenden Chipflanken vorgeschlagen.

Diese bekannte Chipgeometrie, die in erster Linie auf die Verbesserung der Lichtauskopplung über die Vorderseite gerichtet ist, wirft insbesondere folgende Probleme auf:
(i) Bei der Herstellung der schrägen Seitenflächen geht ein erheblicher Flächenanteil der auf dem Wafer vorhandenen aktiven Epitaxieschichtenfolge verloren, weil diese mittels Herstellen eines V-förmigen Grabens von der Seite der aktiven Zone her erzeugt werden.
(ii) Die Dicke der sekundären Fensterschicht ist stark begrenzt, damit eine ausreichend große Chip-Montagefläche erhalten bleibt, bei der
   - kein Verkippen des Chips bei dessen Montage in ein Leuchtdiodengehäuse auftritt,
   - eine Stromaufweitung auf möglichst die gesamte aktive Zone gewährleistet ist,
   - eine ausreichende Wärmeabfuhr von der aktiven Zone gesichert ist und
   - der Chip ausreichende mechnische Stabilität aufweist. Sie beträgt daher bevorzugt nur ca. 10 bis 40% der seitlichen Breite der aktiven Zone.
(iii) Die schrägen Seitenflanken bilden zusammen mit der Chipmontagefläche eines Leuchtdiodengehäuses einen keilförmigen Spalt aus, der bei herkömmlichen Kunststoff-LED-Gehäusen in der Regel mit transparentem Vergußmaterial gefüllt ist. Bei Erhöhung der Bauelementtemperatur während des Betriebs und/oder aufgrund Erhöhung der Umgebungstemperatur, wie sie beispielsweise bei Anwendungen in Kraftfahrzeugen auftritt, wirken aufgrund der hohen thermischen Ausdehnung üblicher Vergußmassen erhebliche mechanische Kräfte auf den Chip, wodurch die Gefahr einer Delamination des Chips von der Chipmontagefläche des Gehäuses im Vergleich zu quaderförmigen Chips erheblich gesteigert ist.
(iv) Die Herstellung der sekundären Fensterschicht ist mit einem erhelblichen technischen Aufwand verbunden, weil diese zusätzlich separat aufgewachsen oder mittels Waferbonden zusätzlich aufgebracht werden muß.
(v) Die untere Fläche des Chips, die die Montagefläche darstellt, ist die kleinste Fläche des Halbleiterkörpers, über der der weitausladende obere Fensterbereich angeordnet ist. Daher beseht die große Gefahr, daß bei einer herkömmlich in der Chipmontage eingesetzten automatischen Chip-Montagetechnik, in der Regel ein Pick- and Place-Verfahren, eine Verkippung des Chips und damit ein Verkippung der Abstrahlachse des entsprechenden Leuchtdiodenbauelements auftreten kann. Diese Gefahr wird reduziert, wenn nur eine primäre Fensterschicht und keine sekundäre Fensterschicht vorhanden ist.
(vi) Die Dicke der eventuell vorhandenen unteren Fensterschicht muß aus den oben unter (ii) und (v) genannten Gründen möglichst gering gehalten werden. Dies bringt jedoch mit sich, daß dieses Fenster zu einem wesentlichen Teil von einem zur Montage von LeuchtdiodenChips üblicherweise verwendeten Klebstoff abgedeckt ist und damit nicht vollständig oder überhaupt nicht zur Lichtauskopplung beitragen kann.

Die Punkte (ii) und (v) nehmen mit abnehmender Kantenlänge des Chips, das heißt mit kleiner werdendem Querschnitt der aktiven Zone, was hinsichtlich möglichst großer Chipausbeute aus einem einzigen Wafer permanent angestrebt wird, an Bedeutung zu, denn je kleiner die Kantenlänge, umso kleiner wird bei der vorgeschlagenen Chipgeometrie sich ergebende Montagefläche des Chips. Die untere Fensterschicht ist aus diesen Gründen möglichst dünn ausgebildet oder weggelassen.

Die aus DE 198 07 758 A1 bekannte Chipgeometrie eignet sich, wenn überhaupt, praktisch sinnvoll nur für Materialsysteme auf der Basis von GaP, in dem sich dicke Schichten beider Leitungstypen epitaktisch erzeugen lassen, die ausreichend elektrisch leitend sind, um insbesondere die vorgeschlagene untere Fensterschicht realisieren und gleichzeitig eine Stromaufweitung auf annähernd die gesamte aktive Zone erzielen zu können.

Im Nitrid-basierten III-V-Halbleitermaterialsystem, das insbesondere GaN, InN und AlN und alle ternären und quaternären Mischkristalle auf der Basis von GaN, InN und AlN, wie beispielsweise AlGaN, InGaN, AlInN und AlGaInN, umfaßt, weisen insbesondere p-leitend dotierte Schichten nur dann einen ausreichend geringen elektrischen Widerstand auf, wenn sie vergleichsweise dünn sind. Ein dickes unteres Fenster entsprechend der oben beschriebenen Anordnung läßt sich daher insbesondere bei herkömmlich verwendeten aktiven Schichtenfolgen auf der Basis von GaN, bei denen die untere Fensterschicht auf der p-leitenden Seite anzuordnen wäre, unter Inkaufnahme der oben dargelegten Schwierigkeiten nur mittels Waferbonden realisieren, was mit hohem technischen Aufwand verbunden ist.

Aus der US 5,233,204 ist eine Geometrie eines lichtemittierenden Halbleiterkörpers auf der Basis von InGaAlP bekannt, bei dem zwischen einem absorbierenden Substrat und einer aktiven Schichtstruktur eine dicke transparente Epitaxieschicht angeordnet ist, die aus GaP, GaAsP oder AlGaAs besteht. Die Seitenflächen der dicken transparenten Epitaxieschicht stehen schräg zur aktiven Schichtstruktur, derart, daß sich eine trichterfömige Schicht ergibt. Dadurch trifft mehr der von der aktiven Schichtstruktur zum Substrat hin ausgesandten Strahlung mit einem Winkel auf die Seitenfläche des transparenten Schicht, der kleiner als der Totalreflexionswinkel ist.

Bei der in der US 5,233,204 vorgeschlagenen Chipgeometrie treten aber erhebliche Lichtverluste auf. Zum einen aufgrund Totalreflexion an der Grenzfläche von der aktiven Schichtstruktur zur dicken transparenten Epitaxieschicht (Brechungsindex_{aktive Schicht} > Brechungsindex_{Fenster}) und nachfolgender Absorption in der aktiven Schichtenfolge. Zum anderen aufgrund Absorption im strahlungsabsorbierenden Aufwachssubstrat. Darüber hinaus erfordert die Herstellung der als dicke transparente Epitaxieschicht hergestellten Fensterschicht einen erheblichen zusätzlichen technischen Aufwand.

Zur Verbesserung der Lichtauskopplung ist an anderer Stelle vorgeschlagen worden, Halbleiterbauelemente mit beispielsweise dreiecksförmigem oder parallelogrammartigem lateralen Querschnitt zu erzeugen; siehe hierzu die Veröffentlichung Song Jae Lee, Seog Won Song: "Efficiency Improvement in Light-Emitting Diodes Based on Geometrically Deformed Chips", SPIE Conference on Light-Emitting Diodes, San Jose, California, January 1999, Seiten 237 bis 248. In diesen Anordnungen werden die Reflexionen im Chip erhöht, weil sich die Reflexionswinkel häufig ändern. Gleichzeitig müssen daher jedoch die strahlungserzeugende Schicht, die Kontakte oder andere Schichten des Halbleiterbauelements so ausgebildet sein, daß sie möglichst wenig Licht absorbieren.

Die Druckschrift JP-A-59 00 088 zeigt ein Halbeiterbauelement nach dem Oberbegriff des Patentanspruchs 1.

Die Druckschrift US-A-5 585 648 beschreibt ein elektrolumineszentes Bauteil sowie dessen Herstellung.

Die Druckschrift JP-A-5 327 012 zeigt eine Licht emittierende Diode.

Die Druckschrift EP-A-0 405 757 beschreibt eine Licht emittierende Diode.

Aufgabe der Erfindung ist es, einen für die Massenproduktion von Lumineszenzdioden-Bauelelmenten geeigneten strahlungsemittierenden Halbleiterkörper der eingangs genannte Art mit verbesserter Lichtauskopplung anzugeben, bei dem insbesondere auch eine hohe Chipausbeute aus einem einzigen Wafer gewährleistet ist. Der Halbleiterkörper soll insbesondere zur Montage in herkömmliche Lumineszenzdiodengehäuse mittels herkömmlicher in der Halbleitertechnik verwendeter automatischer Chip-Montageanlagen geeignet sein.

Weiterhin soll ein Verfahren zum Herstellen eines derartigen Halbleiterkörpers angegeben werden.

Eine weitere Aufgabe der Erfindung besteht darin, ein verbessertes strahlungsemittierendes optisches Bauelement anzugeben.

Diese Aufgaben werden durch ein Halbleiterbauelement mit den Merkmalen des Anspruches 1, durch ein optisches Bauelement mit Merkmalen des Anspruches 8 bzw. durch ein Verfahren mit den Merkmalen des Anspruches 11 gelöst.

Vorteilhafte Weiterbildungen und Ausführungsformen sind Gegenstand der Unteransprüche 2 bis 7, 9 und 10 bzw. 12 bis 14.

Unter "Nitrid-basiert" fallen im Folgenden insbesondere alle binären, ternären und quaternären Stickstoff aufweisenden III-V-Halbleiter-Mischkristalle, wie GaN, InN, AlN, AlGaN, InGaN, InAlN und AlInGaN.

Analog dazu ist im Folgenden mit "SiC-basiert" jedes Mischkristall gemeint, dessen wesentliche Eigenschaften von den Bestandteilen Si und C geprägt sind.

Unter Aufwachssubstrat ist im Folgenden das für das epitaktische Aufwachsen der allerersten Schicht der aktiven Schichtenfolge zugrundegelegte Substrat zu verstehen.

Weiterhin ist im Folgenden unter Vorderseite oder Oberseite diejenige Seite des Halbleiterkörpers gemeint, die der aktiven Mehrschichtfolge in der vorgesehenen Abstrahlrichtung des Bauelements nachgeordnet ist. Mit Rückseite oder Unterseite ist folglich die von der Vorderseite abgewandte Seite des Halbleiterkörpers gemeint.

Bei dem Halbleiterkörper der eingangs genannten Art weist gemäß der Erfindung die transparente Fensterschicht mindestens eine Seitenfläche auf, die, gesehen von der Mehrschichtstruktur über einen ersten Schichtdickenabschnitt der Fensterschicht schräg zu einer senkrecht zur Aufwachsebene der Epitaxieschichten stehenden Mittelachse des Halbleiterkörpers hin verläuft und im weiteren Verlauf zu einer Montagefläche des Halbleiterkörpers hin, das heißt über einen sich an den ersten Schichtdickenabschnitt anschließenden zweiten Schichtdickenabschnitt, parallel zur Mittelachse, das heißt senkrecht zur Montagefläche des Halbleiterkörpers steht.

Die Fensterschicht ist unter Betrachtung der Montagefläche des Halbleiterkörpers als dessen Unterseite ausschließlich unterhalb der Mehrschichtstruktur angeordnet und die schräg verlaufenden Seitenwände des Fensters gehen in senkrecht zur Montagefläche verlaufende Seitenwandteile über und bilden einen quaderartigen, prismenartigen oder zylinderartigen Montagesockel.

Letzteres hat den besonderen Vorteil, daß die Fläche des Halbleiterbauelements auf seiner Unterseite nicht stark verkleinert ist, so daß bei einer automatisierten Montage herkömmlicher Art in ein Gehäuse Kippmomente des Chips reduziert sind und deshalb die Gefahr des Verkippens des Bauelements verringert ist.

Der Montagesockel hat weiterhin den Vorteil, daß der Halbleiterkörper gerade mit dem quaderartigen, prismenartigen oder zylinderartigen unteren Bauelementteil, der ohnehin wenig Licht extrahiert, in ein Gehäuse eingeklebt werden kann. Die Anbindungsfläche des Halbleiterkörpers an eine Montagefläche des Gehäuses ist aufgrund der erfindungsgemäßen Geometrie des Halbleiterkörpers ausreichend groß, um zum einen eine stabile mechanische Verbindung zwischen Halbleiterkörper und Gehäuse und zum anderen eine hinreichend große sowohl elektrische als auch thermische Kontaktfläche zu erzielen.

Ein weiterer besonderer Vorteil, der auf dem quaderartigen, prismenartigen oder zylinderartigen Montagesockel beruht, besteht darin, daß zwischen dem Halbleiterkörper und der Montagefläche eines zugehörigen Gehäuses trotz schräg verlaufender Seitenflächen kein keilförmiger Spalt ausgebildet ist, der bei herkömmlichen Kunststoff-LED-Gehäusen in der Regel mit transparentem Vergußmaterial gefüllt ist. Die Kräfte, die bei Erhöhung der Bauelementtemperatur während des Betriebs und/oder aufgrund Erhöhung der Umgebungstemperatur, wie sie beispielsweise bei Anwendungen in Kraftfahrzeugen in nicht unerheblichem Maße auftritt, den Halbleiterkörper aufgrund der hohen thermischen Ausdehnung üblicher transparenter Vergußmassen von der Montagefläche wegdrücken, sind im Vergleich zu den bekannten Chipgeometrien mit schrägen Fensterflanken deutlich verringert. Folglich ist die Gefahr einer Delamination des Chips von der Montagefläche des Gehäuses, die bei Verwendung eines elektrisch leitfähigen Substrats zudem gleichzeitig als elektrischer Anschluß für den Halbleiterkörper dient, deutlich verringert.

Weiterhin ergibt sich durch die erfindungsgemäße Geometrie des Halbleiterkörpers der Vorteil, daß bei deren Herstellung der Verlust an aktiver Mehrschichtstruktur sehr gering gehalten ist. Nahezu die gesamte Waferfläche kann als aktive Zone für die Halbleiterkörper genutzt werden. Die mit der erfindungsgemäßen Chipgeometrie erzielte Anzahl der Halbleiterkörper pro Wafer ist gegenüber der Herstellung herkömmlicher quaderförmiger Halbleiterkörper unverändert.

Weiterhin ergibt sich der Vorteil, daß die vordere Bauelementfläche groß genug ist, um einen großen Teil der von der aktiven Zone nach vorne ausgesandten Strahlung direkt nach vorne auskoppeln zu können, ohne daß weitere Verluste, insbesondere Absorptionsverluste, in einem zusätzlichen oberen Fenster entstehen.

Die erfindungsgemäße Geometrie des Halbleiterkörpers eignet sich besonders bevorzugt insbesondere für Halbleiterkörper mit einer Nitrid-basierten aktiven Mehrschichtstruktur (das heißt aus dem Materialsystem In_{1-x-y}AlₓGa_{y}N mit 0≤x≤1, 0≤y≤1 und x+y≤1) auf einem SiC-basierten Substrat oder einem anderen transparenten Substrat, dessen Material einen größeren Brechungsindex aufweist als die aktive Mehrschichtstruktur. Ein Grund hierfür ist, daß Nitrid-basierte Schichten nur dann einen ausreichend geringen elektrischen Widerstand aufweisen, wenn diese sehr dünn sind. Dies trifft ganz besonders für p-dotierte derartige Schichten zu.

Der erfindungsgemäße Halbleiterkörper ist aufgrund eines gegenüber herkömmlichen quaderförmgen Chips verbesserten Überlapps des Winkelbereichs von auf die Substratflanken auftreffender Strahlung mit dem durch die Substratflanken auskoppelbaren Winkelbereich in der Lage, einen vergleichsweise großen Teil der in der aktiven Zone erzeugten Strahlung bereits beim ersten Chipdurchlauf, das heißt beim ersten Auftreffen von Strahlung auf die Chipoberfläche, auszukoppeln. Damit ist die Totalreflexion an den Seitenflächen reduziert, die direkte Lichtauskopplung erhöht und die Absorption durch lange optische Wege und viele Reflexionen im Bauelement bzw. angrenzenden Fensterbereichen verringert.

Der schräge Teil der Seitenfläche ist besonders bevorzugt derart ausgebildet, daß ein Großteil der von dem Halbleiterbauelement durch die Seitenflanken ausgekoppelten Strahlung bezogen auf die Mittelachse des Halbleiterbauelements im Winkelbereich zwischen 50° und 90° abgestrahlt wird. Damit wird vorteilhafterweise erreicht, daß bei herkömmlich für Lumineszenzdioden-Bauelemente verwendeten Gehäuse-Bauformen mit Reflektor die seitlich durch die Fensterschicht ausgekoppelte Strahlung auf die schräg stehenden Seitenwände des Reflektors treffen. Dies hat den bedeutenden Vorteil, daß die Strahlung in einem vergleichsweise stumpfen Winkel auf die Reflektor-Innenwände trifft, wodurch insbesondere bei Kunststoff-Reflektorwänden eine verbesserte Reflexion erreicht wird.

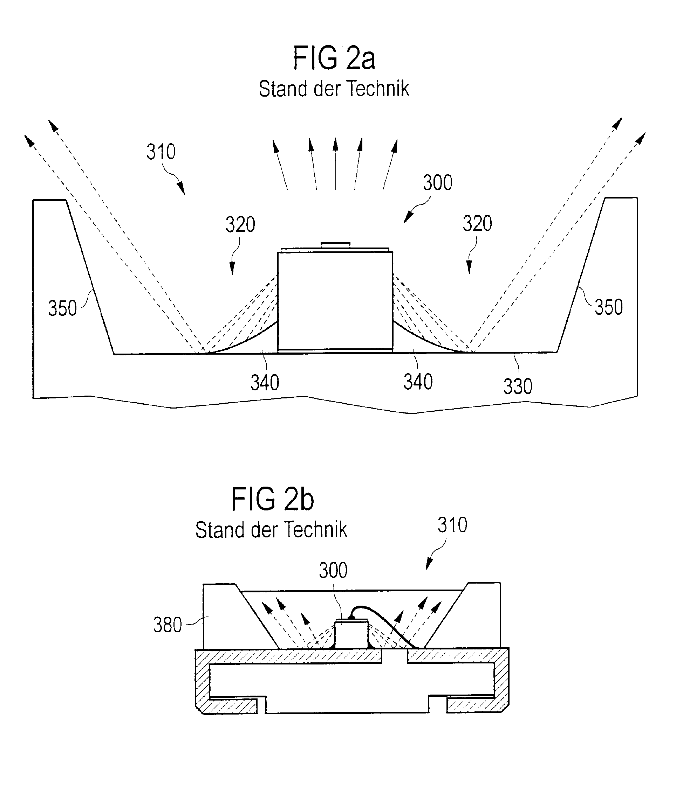

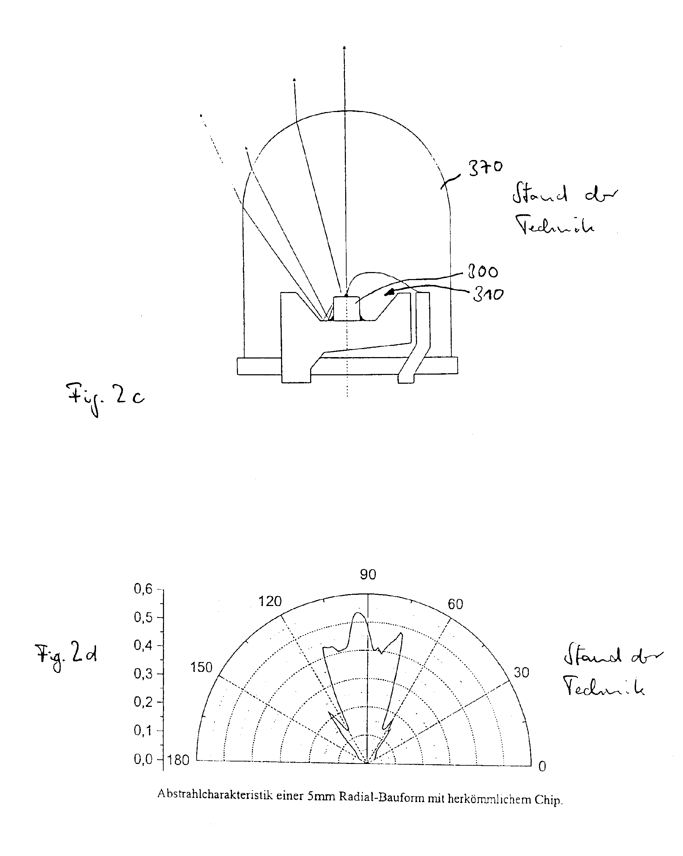

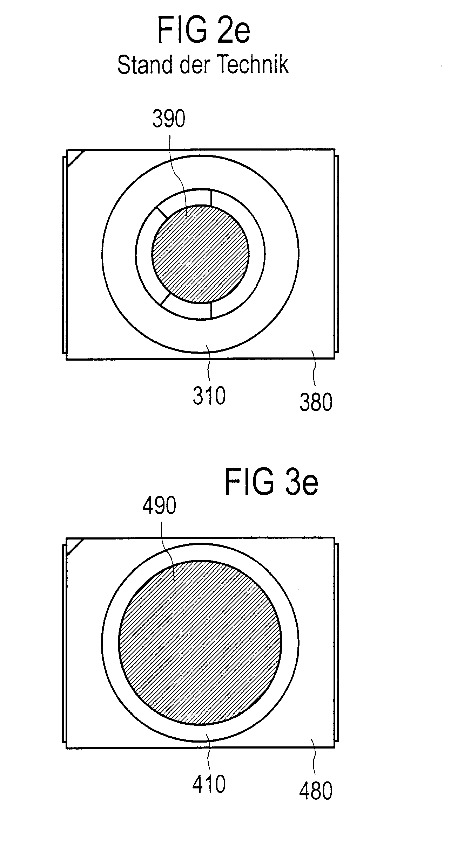

Bei herkömmlichen quaderförmigen Chips trifft, wie in Figur 2 gezeigt, der Hauptteil der durch die Fensterschicht ausgekoppelten Strahlung wegen des steilen Abstrahlwinkels von den Chipflanken (vgl. Figur 2) auf den Reflektorboden, von dem zum einen wegen des steileren Auftreffwinkels der Strahlung und zum anderen wegen der unvermeidbaren teilweisen Abdeckung des Bodens mit Klebstoff vergleichsweise wenig Strahlung reflektiert wird.

Weiterhin besonders bevorzugt weist das Material der Fensterschicht einen größeren Brechungsindex auf als das an diese angrenzende Material der aktiven Mehrschichtstruktur. Dadurch wird vorteilhafterweise die Reflexion der von der aktiven Zone nach hinten ausgesandten Strahlung an der Grenzfläche zwischen Mehrschichtstruktur und Fensterschicht vermindert und es erfolgt eine Komprimierung der in die Fensterschicht eingekoppelten Strahlung.

Die erfindungsgemäße Chipgeometrie wird besonders bevorzugt bei Nitrid-basierten LED-Chips verwendet, bei dem die aktive Mehrschichtstruktur auf einem SiC- oder SiC-basierten Aufwachs-Substrat hergestellt ist. Hier gilt Brechungsindexₐₖₜᵢᵥₑ Schicht > Brechungsnindex_{substrat}.

Bei einem Chip mit quadratischem Querschnitt beträgt das Verhältnis Kantenlänge Mehrschichtstruktur/Kantenlänge Montagesockel besonders bevorzugt 1,2 bis 1,6. Bei ebenen schrägen Seitenflächen des Fensters schließen diese mit der Mittelachse des Halbleiterbauelements einen Winkel α ein, für den gilt 20° ≤ α ≤ 40°.

Bei dieser Ausgestaltung ist einerseits eine gute Stromaufweitung auf die Fläche der Mehrschichtstruktur gewährleistet und liegt andererseits der Spannungsabfall am Montagesockel im Betrieb des Halbleiterbauelements in einem akzeptablen Bereich.

In einer weiteren vorteilhaften Ausgestaltung ist vorgesehen, daß mindestens der schräge Bereich der Fensterschicht aufgerauht ist.

Besonders vorteilhaft ist es, wenn das Fenster das Aufwachssubstrat ist, wie zum Beispiel bei einer GaN-basierten Mehrschichtstruktur auf einem das Fenster bildenden SiC-basierten Aufwachssubstrat.

Bei einem strahlungsemittierenden optischen Bauelement gemäß der Erfindung, das ein strahlungsemittierendes Halbleiterbauelement mit den oben offenbarten Merkmalen enthält, ist das Halbleiterbauelement in einer Reflektor-Ausnehmung eines Gehäuse-Grundkörpers montiert. Die Reflektor-Ausnehmung weist bevorzugt eine vorzugsweise ebene Bodenfläche auf, auf die das strahlungsemittierende Halbleiterbauelement montiert ist und die von einer ebenen, schräg zur Bodenfläche stehenden Reflektorwand zumindest teilweise umschlossen ist. Der Gehäuse-Grundkörper ist aus einem reflektierenden Material, insbesondere aus einem entsprechenden Kunststoff, der vorzugsweise mit reflexionssteigerndem Material gefüllt ist, gefertigt und weist elektrische Anschlußelemente auf. Das Halbleiterbauelement ist mit seiner Montagefläche auf die Bodenfläche aufgesetzt und mittels Klebstoff mit dieser verbunden.

Die Höhe des Montagesockels ist derart gewählt, daß die durch den schrägen, konkaven oder stufenartigen Bereich der Fensterschicht ausgekoppelte Strahlung zu einem möglichst großen Teil auf die schräg stehenden Reflektorwände und nicht auf die Bodenfläche der Reflektor-Ausnehmung trifft und zur Abstrahlrichtung des Bauelements hin reflektiert wird.

Da die schrägen Wandflächen nicht beliebig nahe an das Halbleiterbauelement herangeführt werden können - die Bodenfläche muß nämlich genügend Platz bieten, um erstens das Halbleiterbauelement mit einer gewissen Positionierungstoleranz in das Gehäuse montieren und zweitens eine Bonddrahtverbindung von der Oberseite des Chips zu einem externen elektrischen Anschlußelement herstellen zu können - stellt der Montagesockel ein wesentliches Element des erfindungsgemäßen Halbleiterbauelements dar.

Bei einer besonderen Ausführungsform sind die seitlichen Reflektorwände derart parabolartig ausgebildet, daß die über den schrägen Bereich der Fensterschicht ausgekoppelte Strahlung weitestgehend parallel in eine vorgegebene Richtung zur aktiven Schicht nach oben reflektiert werden.

Die in Bezug auf die Bodenfläche flachere Abstrahlung bringt insbesondere bei Reflexion an Kunststoffoberflächen den weiteren bedeutenden Vorteil mit sich, daß die Strahlungsabsorption verringert ist, denn die Absorption ist umso geringer, je flacher der Einfallswinkel der Strahlung auf die Kunststoffoberflächen ist.

Die Reflektorwände können vorteilhafterweise auf einfache Weise hochreflektierend ausgebildet sein, beispielsweise mittels Al- oder Ag-Beschichtung. Die Gefahr einer Kontamination der schräg stehenden Reflektorwände mit Klebstoff bei der Montage des Halbleiterbauelements in das Gehäuse besteht zudem nicht.

Die Kontaktmetallisierung an der Unterseite des Montagesokkels ist bevorzugt ein Gitterkontakt. Es wurde festgestellt, daß die Rückreflexion der zur Rückseite des Chips hin ausgesandten Strahlung in Richtung Vorderseite verbessert ist, wenn die Rückseiten-Kontaktmetallisierung nicht ganzflächig ausgebildet ist.

Bei einem Verfahren zur Herstellung eines strahlungsemittierenden Bauelements gemäß der Erfindung ist vorgesehen, daß nach dem Aufbringen und gegebenenfalls Strukturieren der aktiven Mehrschichtstruktur auf einem großflächigen Substratwafer in den so erzeugten Wafer von der späteren Halbleiterbauelementrückseite her, d.h. von derjenigen Seite der Fensterschicht her, welche von der aktiven Mehrschichtstruktur abgewandt ist, mit einem Sägeblatt mit Formrand bis zu einer vorgegebenen Tiefe eingesägt wird, bei der der blattförmige Teil des Sägeblattes, in dem die Oberflächen des Sägeblattes parallel verlaufen, in den Substratwafer teilweise, bevorzugt bis zur Höhe des Montagesockels eindringt.

Unter Formrand ist vorliegend eine nach bestimmten Maßgaben geformte Stirnseite des Sägeblattes zur Herstellung einer vorgesehenen Geometrie des Sägegrabens zu verstehen. Der Formrand weist vorliegend die Negativ-Form des schrägen Teiles der Fensterschicht auf und ist folglich V-förmig ausgebildet.

Nach diesem Form-Sägeschritt erfolgt das Vereinzeln der großflächigen Waferanordnung mit der aufgebrachten Mehrschichtstruktur in eine Vielzahl von strahlungsemittierenden Halbleiterbauelementen, indem der Waferverbund entlang den Sägeschnitten mittels Brechen oder mittels eines zweiten Sägeschnittes durchtrennt wird.

Besonders bevorzugt erfolgt vor dem Einsägen mittels dem Sägeblatt mit Formrand ein Durchtrennen der aktiven Mehrschichtstruktur entlang der vorgesehenen Sägeschnitte, vorzugsweise mittels Ätzen.

Bei einer weiterhin bevorzugten Ausführungsart des Verfahrens ist vorgesehen, daß die Kontaktflächen, insbesondere gebildet durch Metallisierungsschichten, bereits vor dem Einsägen der Waferrückseite hergestellt werden.

Bei einer besonders bevorzugten Weiterbildung des Verfahrens wird zunächst auf einem SiC-basierten Substratwafer eine GaN-basierte Epitaxieschichtenfolge aufgebracht, die geeignet ist, Strahlung im ultravioletten, blauen und/oder grünen Spektralbereich auszusenden. Das Substratmaterial ist vorzugsweise so gewählt, daß es zumindest für einen Großteil der von der aktiven Zone der Mehrschichtstruktur ausgesandten Strahlung zumindest teildurchlässig ist und einen größeren Brechungsindex aufweist als das Material der Epitaxieschichtenfolge.

Nachfolgend werden auf der Vorderseite der Epitaxieschichtenfolge und auf der Rückseite des Substratwafers Kontaktschichten aufgebracht, bevor danach die Epitaxieschichtenfolge bevorzugt mittels Ätzen zu einer Vielzahl von voneinander getrennten aktiven Mehrschichtstrukturen separiert wird.

Danach erfolgt der Form-Sägeschritt von derjenigen Seite des Substratwafers her, welche von der Epitaxieschichtenfolge abgewandt ist.

Weitere bevorzugte Ausführungsformen und Weiterbildungen der Erfindung ergeben sich aus den nachstehend in Verbindung mit den Figuren 1a bis 11 beschriebenen Ausführungs- und Erläuterungsbeispielen. Es zeigen:
- Figur 1a: einen schematischen Querschnitt durch eine Ausführungsform des erfindungsgemäßen lichtemittierenden Halbleiterbauelements,
- Figuren 1b und 1c: schematische Querschnitte durch ein Erläuterungsbeispiel des lichtemittierenden Halbleiterbauelements,
- Figur 2a bis 2e: schematische Darstellungen des Abstrahlverhaltens eines herkömmlichen quaderförmigen Halbleiterbauelements in einer Reflektorausnehmung eines Bauelementgehäuses,
- Figur 3a bis 3e: schematische Darstellungen des Abstrahlverhaltens eines erfindungsgemäßen Halbleiterbauelements mit ebenen schrägstehenden Seitenflächen einer Fensterschicht in einer Reflektorausnehmung eines Bauelementgehäuses,
- Figuren 4a bis 4c: einen Vergleich der Abstrahlcharakteristik eines herkömmlichen lichtemittierenden Halbleiterbauelements mit denen zweier erfindungsgemäßer lichtemittierender Halbleiterbauelemente mit ebenen schrägstehenden Seitenflächen einer Fensterschicht,
- Figur 5: ein Diagramm, das den optischen Auskoppelwirkungsgrad eines erfindungsgemäßen Halbleiterbauelements mit ebenen schrägen Seitenflächen der Fensterschicht in Abhängigkeit vom Winkel darstellt, den die schrägstehenden Seitenflächen mit der senkrechten Mittelachse des Halbleiterbauelements einschließen,
- Figur 6: Vergleich der Fernfeld-Charakteristik eines herkömmlichen quaderförmigen Halbleiterbauelements mit der eines erfindungsgemäßen Halbleiterbauelements mit ebenen schrägen Seitenflächen einer Fensterschicht, jeweils montiert auf eine ebene reflektierende Montagefläche,
- Figur 7: eine schematische Querschnittsdarstellung eines erfindungsgemäßen lichtemittierenden optischen Bauelements mit parabelartigen Reflektorwänden,
- Figuren 8 bis 11: Ausführungsschritte für ein Verfahren zur Herstellung eines erfindungsgemäßen lichtemittierenden Halbleiter-Bauelements, und
- Figur 12: eine perspektivische Ansicht eines besonders bevorzugten erfindungsgemäßen Halbleiterbauelements.

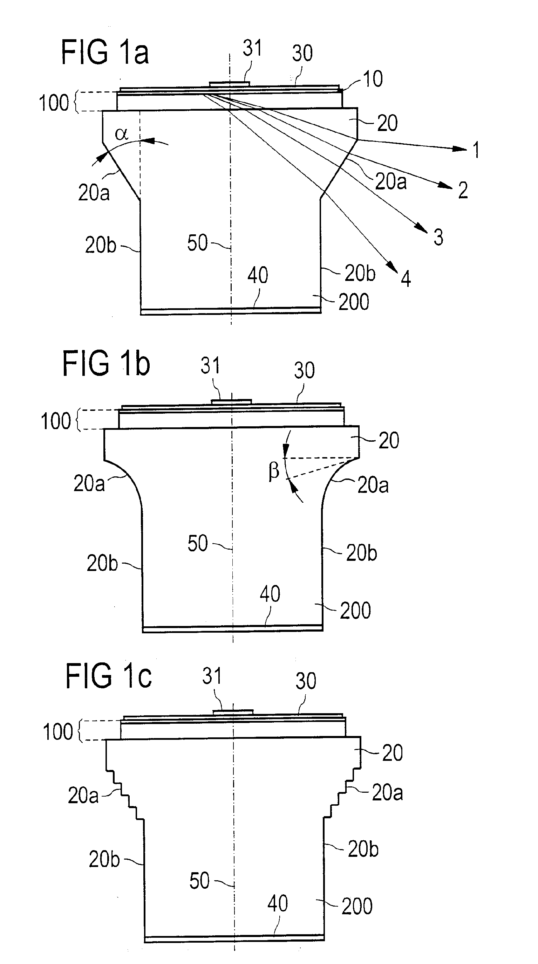

Figur 1a zeigt rein schematisch einen Querschnitt durch einen erfindungsgemäßen lichtemittierenden Halbleiterkörper. Eine das Licht erzeugende aktive Schicht 10, zum Beispiel eine Einfach-Quantentopf(SQW für Single Quantum Well)- oder Mehrfach-Quantentopf(MQW für Multi Quantum Well)-Struktur auf der Basis von InGaN, liegt innerhalb einer Mehrschichtstruktur 100, die beispielsweise insgesamt aus einer Mehrzahl von Nitrid-basierten III-V-Halbleiterschichten besteht. Der genaue Aufbau einer solchen Mehrschichtstruktur ist abhängig vom Materialsystem und den gewünschten Eigenschaften des Bauelements. Einzelheiten hierzu sind aus dem Stand der Technik bekannt und werden von daher im vorliegenden Zusammenhang nicht näher erläutert.

Die Mehrschichtstruktur 100 ist zum Beispiel durch metallorganische Gasphasenepitaxieverfahren auf einer Fensterschicht 20 hergestellt, die an ihrer Unterseite einen elektrischen Kontakt 40 aufweist. Oberhalb der Mehrschichtstruktur 100 befindet sich ein zweiter elektrischer Kontakt 30, der im Ausführungsbeispiel großflächig die obere Oberfläche der Mehrschichtstruktur 100 bedeckt. Der elektrische Kontakt 30 ist so dünn ausgeführt, daß er für das aus der aktiven Schicht nach oben abgestrahlte Licht weitestgehend durchlässig ist. Dies ist bei einer GaN-Struktur beispielsweise durch eine Platinschicht von wenigen nm, z.B. 6 nm möglich. Aus diesem Grund kann der Kontakt großflächig die Oberseite der Mehrschichtstruktur abdecken und eine großflächige Stromeinprägung in die aktive Schicht 10 erfolgen.

Auf dem Kontakt 30 ist ein undurchsichtiger kleinflächiger Bondpad 31 vorgesehen.

Bei hinreichender elektrischer Leitfähigkeit einer oberhalb der aktiven Schicht 10 angeordneten Halbleiterschicht kann der großflächige transparente Kontakt 30 weggelassen und nur ein kleinflächiger strahlungsundurchlässiger Bondpad 31 vorgesehen sein. Strahlung kann folglich seitlich vom Bondpad 31 austreten.

In dem dargestellten Ausführungsbeispiel ist die Fensterschicht 20 von einem Aufwachssubstrat gebildet, vorzugsweise bestehend aus Siliziumcarbid oder aus einem auf SiC basierenden Material, während die Mehrschichtstruktur 100 auf Galliumnitridbasis ausgebildet ist. Das bedeutet, daß die Mehrschichtstruktur 100 neben Stickstoff die Elemente Indium, Aluminium und/oder Gallium enthält. In diesem Materialsystem sind p-dotierte Schichten nur dann hinreichend elektrisch leitend, wenn sie vergleichsweise dünn sind.

Der Metallkontakt 40 auf der Rückseite der Fensterschicht, das heißt auf der Rückseite des Aufwachssubstrats 20 ist vorzugsweise als Gitternetz ausgebildet. Dadurch wird überraschenderweise die Reflektivität der Rückseite der Fensterschicht 20 erhöht.

In einem anderen Materialsystem können die Schichten der Mehrschichtenfolge 100 und das Substrat anders ausgebildet sein. Beispielsweise ist im Materialsystem InGaAlP eine Leitfähigkeit bei dicken Schichten möglich. Substrat kann Saphir oder SiC sein. Während deshalb im diesem Materialsystem auch oberhalb der Mehrschichtstruktur 100 noch ein transparentes Fenster angeordnet sein kann, ist die Ausbildung eines derartigen epitaktisch aufgewachsenen Fensters im Materialsystem von Galliumnitrid nicht möglich.

Gemäß der Erfindung ist vorgesehen, daß das in diesem Ausführungsbeispiel von dem Aufwachssubstrat gebildete transparente Fenster 20 an seiner Oberseite an der Mehrschichtstruktur 100 anliegt und daß die Seitenoberfläche des transparenten Fensters im Übergangsbereich zur Mehrschichtstruktur zumindest teilweise einen spitzen Winkel α mit der Mehrschichtstruktur 100 einschließt. Die zunächst schräg unter dem Winkel α zur Mehrschichtstruktur bzw. zur aktiven Schicht 10 verlaufenden Seitenwände 20a gehen in Richtung des unteren Metallkontakts 40 in eine senkrecht zur Mehrschichtstruktur verlaufende Seitenwand 20b über, so daß der untere Teil des Fensters 20 und damit des Aufwachssubstrats unmittelbar angrenzend an den Metallkontakt 20 für sich betrachtet einen quaderförmigen Aufbau hat und als Montagesockel 200 dient. Die Höhe des Montagesockels ist, um den Spannungsabfall möglichst niedrig zu halten, möglichst gering und liegt beispielsweise im Bereich zwischen 100 und 200µm.

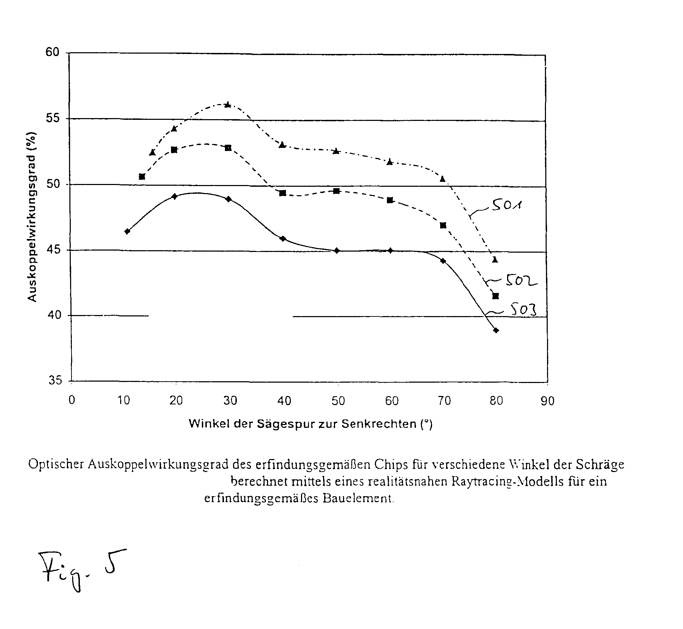

Der von den ebenen schräg stehenden Seitenwänden 20a und einer Mittelachse 50 des Halbleiterkörpers eingeschlossene Winkel α liegt in einem Bereich von z.B. 20° bis 80°, je nach gewünschtem Abstrahlverhalten. Besonders bevorzugt liegt der Winkel α zwischen 20° und 30°. Der Auskoppelwirkungsgrad ist in diesem Bereich am höchsten (vgl. Figur 5).

Die Fensterschicht besteht aus Siliziumcarbid und die Mehrschichtstruktur ist auf Galliumnitridbasis gefertigt. Der detaillierte Aufbau derartiger Mehrschichtstrukturen ist dem Fachmann bekannt und wird daher an dieser Stelle nicht näher erläutert. Die von der aktiven Schicht 10 nach oben ausgesandte Strahlung wird nach oben in Richtung des Metallkontakts 30 unmittelbar aus der Mehrschichtenstruktur 100 ausgekoppelt. Nach unten, das heißt zur Fensterschicht 20 hin ausgesandte Strahlung wird zunächst an der Grenzfläche zwischen der Mehrschichtstruktur 100 und der Fensterschicht 20 in dieses hinein gebrochen. Aufgrund der Tatsache, daß diese Strahlen, die nach außen in Richtung auf den Aussenraum des Halbleiter-Bauelements gerichtet sind, mit einem Winkel auf die schräg stehenden Seitenoberflächen 20a des Fensters 20 treffen, der kleiner als der Grenzwinkel der Totalreflexion ist, können diese Lichtstrahlen aus dem Fenster bzw. dem Substrat 20 ausgekoppelt werden, wie in Figur 1a durch die Strahlen 1 bis 4 angedeutet ist.

Im Bereich der senkrecht zur aktiven Schicht verlaufenden Seitenoberflächen 20b des Montagesockels 200 wird dagegen fast kein Licht ausgekoppelt. Dies führt dazu, daß im oberen Teil des Substrats 20 mit den abgeschrägten Seitenoberflächen 20a Licht nach außen ausgekoppelt werden kann, während im unteren Teil des Substrats 20 mit den senkrecht zur Montagefläche stehenden Seitenflächen 20b nahezu kein Licht nach außen ausgekoppelt wird und dieses damit dunkel bleibt.

Bei der Betrachtung eines im Betrieb befindlichen erfindungsgemäßen lichtaussendenden Halbleiterbauelements erscheinen deshalb die Oberflächen der Mehrschichtstruktur und die schrägen Seitenoberflächen des Substrats leuchtend, während der Montagesockel 200 des Substrats 20 dunkel bleibt. Das in den Bereich mit den senkrecht stehenden Seitenflächen 20b eingestrahlte Licht wird an den Seitenwänden 20b totalreflektiert und nachfolgend an der Unterseite des Substrats 20 zur Vorderseite des Halbleiterkörpers hin reflektiert.

Auf diese Weise ist es möglich, im Vergleich zu quaderförmigen Chips auf der Basis von Nitrid-Halbleiter auf SiC-Substrat eine Lichtsteigerung von mehr als 80% zu erzielen. Das Erläuterungsbeispiel der Figur 1c unterscheidet sich von dem Ausführungsbeispiel der Figur 1a im wesentlichen dadurch, daß die Seitenoberflächen 20a des Substrats 20 keine ebenen schrägstehenden Flächen sind, sondern stufenartig zur senkrechten Mittelachse 50 des Halbleiterkörpers hin verlaufen.

Bei dem in Figur 1b dargestellten Erläuterungsbeispiel sind an Stelle der ebenen schrägstehenden Seitenflächen 20a der Ausführungsform von Figur 1a von außerhalb des Halbleiterkörpers gesehen konkave Seitenflächen 20a vorgesehen. Hierbei schließt das Substrat 20 mit der aktiven Schichtenfolge 100 gesehen von der aktiven Schichtenfolge 100 zunächst einen spitzen Winkel β ein. Im weiteren Verlauf in Richtung auf die Rückseite des Substrats 20 zu gehen die Seitenwände in senkrecht zur Rückseite des Substrats 20 stehende Seitenwände 20b des Montagesockels 200 über. Auf diese Weise ergibt sich gesehen von der Mehrschichtstruktur 100 ein fließender Übergang der Seitenoberflächen vom zunächst spitzen Winkel β bis zur senkrecht zur aktiven Schicht verlaufenden Seitenoberfläche des quaderartigen Montagesockels 200.

In den Figuren 1a bis 1c hat das Substrat 20 einen höheren Brechungsindex als die Mehrschichtstruktur 100.

Bei sämtlichen Ausführungs- und Erläuterungsformen können die Seitenflächen 20a und/oder 20b beispielsweise mittels Ätzen aufgerauht sein. Bei Aufrauhung der Seitenflächen 20b des Montagesockels 200 kann auch aus diesem Strahlung ausgekoppelt werden.

Die Dicke des Substrats bzw. Fensters 20 in allen Ausführungen der Figuren 1a bis 1c liegt besonders bevorzugt zwischen 100µm und 250µm (Grenzwerte eingeschlossen). Ein Klebekontakt an der Unterseite des Fensters in einem Gehäuse sollte dabei die Höhe des Montagesockels 200 nicht überschreiten. Vorteil einer derartigen Konstruktion ist dabei eine größere Standfläche durch den an den Seiten des Montagesockels herausquellenden Kleber, der eine bessere Wärmeabfuhr und eine größere Stabilität erzeugt.

Die Figur 2a zeigt das Abstrahlverhalten eines in einer Reflektorwanne 310 eines Bauelementgehäuses montierten herkömmlichen quaderförmigen Halbleiterkörpers 300. Der Strahlengang der über die Substratflanken ausgekoppelten Strahlung ist durch die gestrichelten Linien 320 mit den Pfeilspitzen angedeutet. Die Strahlungsauskopplung über die Flanken des Substrats 20 erfolgt nur in einem sehr steilen Winkelbereich, so dass diese zuerst auf die Bodenfläche 330 der Reflektorausnehmung 310 bzw. auf den Leitkleber 340, mit dem der Halbleiterkörper 300 kontaktiert und befestigt ist treffen. Kann die Reflektorwanne nicht klein genug gehalten werden, treffen die über die Flanken ausgekoppelten Strahlen nach der Reflexion an der Bodenfläche größtenteils nicht einmal mehr die Seitenwände der Reflektorwanne, wie in Figur 2b am Beispiel einer vorgehäusten oberflächenmontierbaren Gehäusebauform mit einer Reflektorwanne in einem strahlungsundurchlässigen Grundkörper schematisch dargestellt.

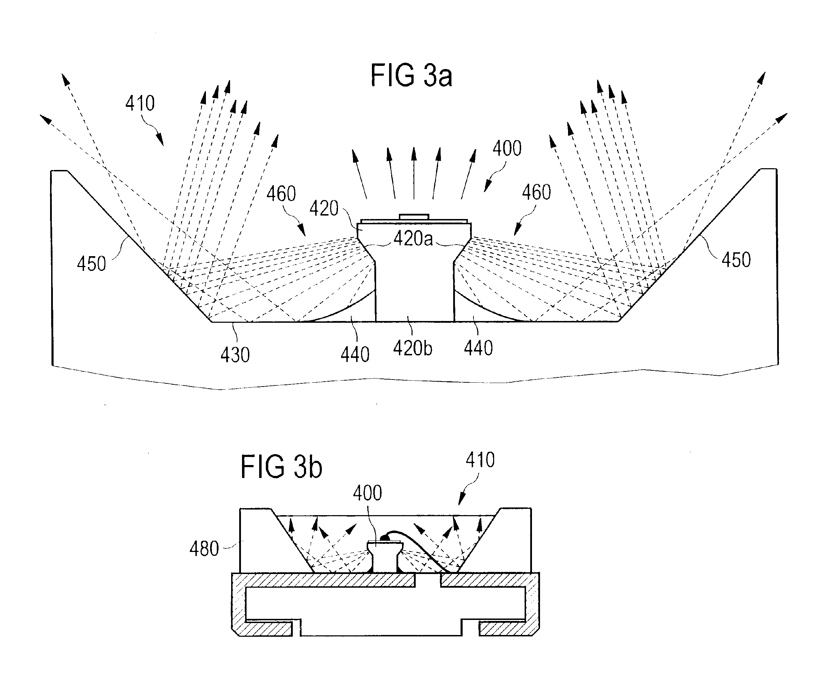

Bei dem in Figur 3a dargestellten Abstrahlverhalten eines in einer Reflektorwanne 410 eines Bauelementgehäuses mittels Leitkleber 440 montierten erfindungsgemäßen Halbleiterkörpers 400 mit einem strahlungsdurchlässigen Substrat 420 mit schrägstehenden Seitenflächen 420a und einem quaderartigen Montagesockel 420b ist ersichtlich, daß ein Großteil der über die Seitenflächen 420a ausgekopptelten Strahlung 460 nicht auf den Wannenboden 430, sondern unmittelbar auf die Reflektorwände 450 treffen und dort zur Hauptabstrahlrichtung des Halbleiterkörpers hin reflektiert werden. In Figur 3b ist der mit einem erfindungsgemäßen Halbleiterchip erzielbare Strahlengang in einer vorgehäusten oberflächenmontierbaren Gehäusebauform mit einer Reflektorwanne in einem strahlungsundurchlässigen Grundkörper schematisch dargestellt. Aufgrund der Tatsache, dass mit der erfindungsgemäßen Chipgeometrie mehr Strahlung über die Fenstersubstratflanken ausgekoppelt wird und ein Großteil dieser Strahlung unmittelbar auf die Reflektor-Seitenwände trifft, wird mehr "Rückseiten"-Strahlung stärker zur Hauptabstrahlrichtung des Bauelements hin zurückreflektiert.

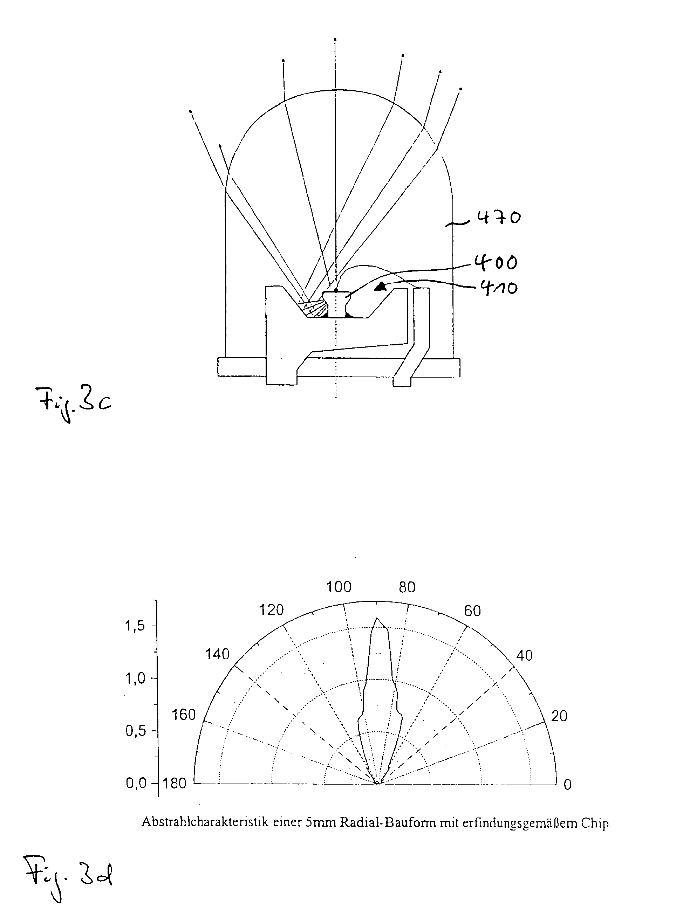

Die in den Figuren 2c, 2d, 3c und 3d gezeigte Gegenüberstellung einer sogenannten Radial-Bauform für LED-Bauelemente, bei der der LED-Chip in einen Metallreflektor geklebt ist und der umgebende Verguß 370 bzw. 470 eine Linsenform aufweist, einerseits mit herkömmlichem quaderförmigen LED-Chip (Figuren 2c und 2d) und andererseits mit einem erfindungsgemäßen LED-Chip gemäß Figur 1a (Figuren 3c und 3d) verdeutlicht Folgendes:
Figur 2d zeigt das Fernfeld einer 5mm Radial-Bauform mit einem herkömmlichen quaderförmigen InGaN-besierten LED-Chip auf SiC-Fenstersubstrat. Der Verguß ist klar, so dass keine diffuse Streuung auftritt. Das Maximum der Abstrahlung liegt zwar in Vorwärtsrichtung, es zeigen sich aber bei ca. 15° Abweichung von der Vertikalen Nebenmaxima. Diese sind auch bei visueller Betrachtung sichtbar und können in bestimmten Anwendungen Probleme bereiten. Der Strahlengang zu dieser Radial-Bauform mit herkömmlichem LED-Chip ist in Figur 2c schematisch dargestellt.

In Figur 3d ist die Abstrahlcharakteristik der gleichen Radial-Bauform mit einem erfindungsgemäßen LED-Chip gemäß Figur 1a gezeigt. Zum einen ist die Strahlungsleistung gegenüber der Bauform mit herkömmlichen LED-Chip deutlich erhöht, zum anderen sind die bei der Bauform mit herkömmlichem LED-Chip ausgeprägten Nebenmaxima hier nicht vorhanden. Der visuelle Eindruck des abgestrahlten Lichtes ergibt ein deutlich homogeneres Leuchtbild dieser LED-Bauform. Der Strahlengang zu dieser Radial-Bauform mit erfindungsgemäßen LED-Chip ist in Figur 3c schematisch dargestellt.

Beim herkömmlichen quaderförmigen LED-Chip wird zwar auch Strahlung in Rückwärtsrichtung abgegeben. Der Winkel des Hauptanteils dieser Strahlung gegenüber der senkrechten Chipachse beträgt aber maximal etwa 40°. Damit kann diese Strahlung die schrägen Seitenwände des Reflektors nicht erreichen. Sie trifft damit nur den flachen Reflektorboden oder wird im Leitkleber, mit dem der LED-Chip befestigt ist, absorbiert. Wie in Figur 2c gezeigt, ist dieser Abstrahlwinkel so ungünstig, dass die Strahlung nicht mehr exakt in Vorwärtsrichtung gebracht werden kann. Da außerdem die nach rückwärts gerichtete Strahlung eine hohe Richtcharakteristik aufweist, ergeben sich die beobachteten Nebenmaxima.

Durch die schrägstehenden Substratwände im Fenstersubstrat wird vorteilhafterweise in Rückwärtsrichtung einerseits die Strahlungsleistung und anderseits der Auskoppel-Winkelbereich vergrößert. Die Strahlung trifft nunmehr die schrägen Seitenwände des Reflektors uns wird daher besser zur Linse hin reflektiert. Der größere Winkelbereich bewirkt zudem, dass keine Nebenmaxima mehr auftreten.

Bei der in den Figuren 2b und 3b gezeigten oberflächenmontierbaren Bauform mit strahlungsundurchlässigem Gehäusegrundkörper 380 bzw. 480 mit Reflektorausnehmung 310 bzw. 410 wird aufgrund des begrenzten Rückwärts-Abstrahlwinkels eines herkömmlichen quaderförmigen LED-Chips nur ein begrenzter Bereich der Bauform ausgeleuchtet(angedeutet durch den dunklen kreisförmigen Bereich 390 in der Figur 2e). Im Gehäuse trifft die nach rückwärts ausgesandte Strahlung nur den planen Boden der Reflektorausnehmung. Der Kunststoff, aus dem der Gehäusegrundkörper üblicherweise besteht, ist nicht perfekt reflektierend, wodurch ein Teil der Strahlung absorbiert wird.

Wird diese oberfächenmontierbare Bauform aber mit einem erfindungsgemäßen LED-Chip gemäß Figur 1a versehen, so trifft auch hier ein großer Teil der Strahlung auf die schrägen Reflektorwände (vgl. Figur 3e). Diese können auf einfache Weise zum Beispiel mittels einer reflexionssteigernden Beschichtung versehen sein. Mit einem erfindungsgemäßen LED-Chip wird, wie in Figur 3e durch den dunklen kreisförmigen Bereich 490 angedeutet, ein wesentlich größerer Reflektorbereich ausgeleuchtet.

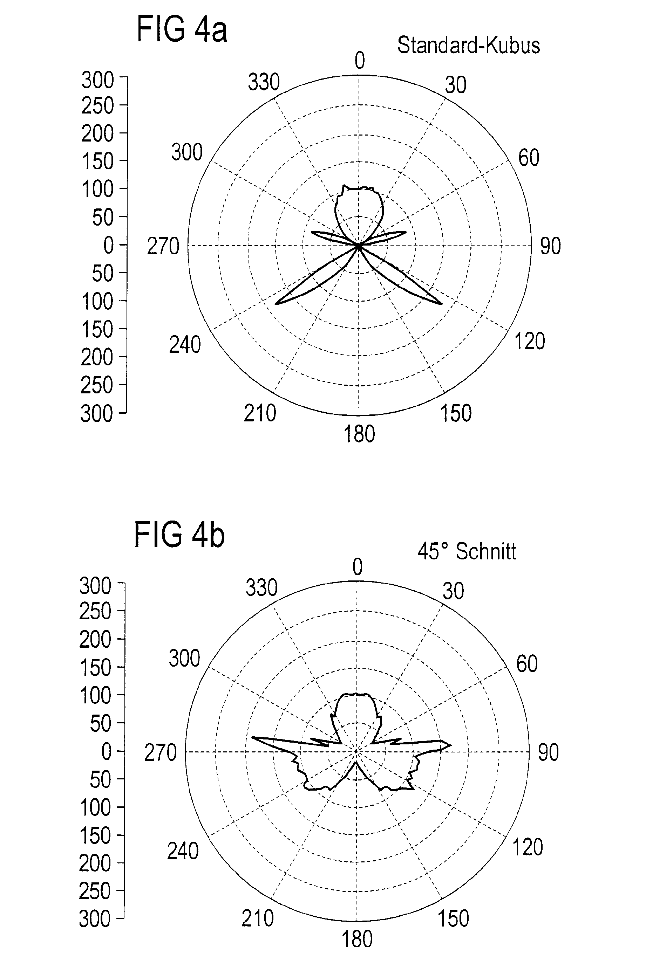

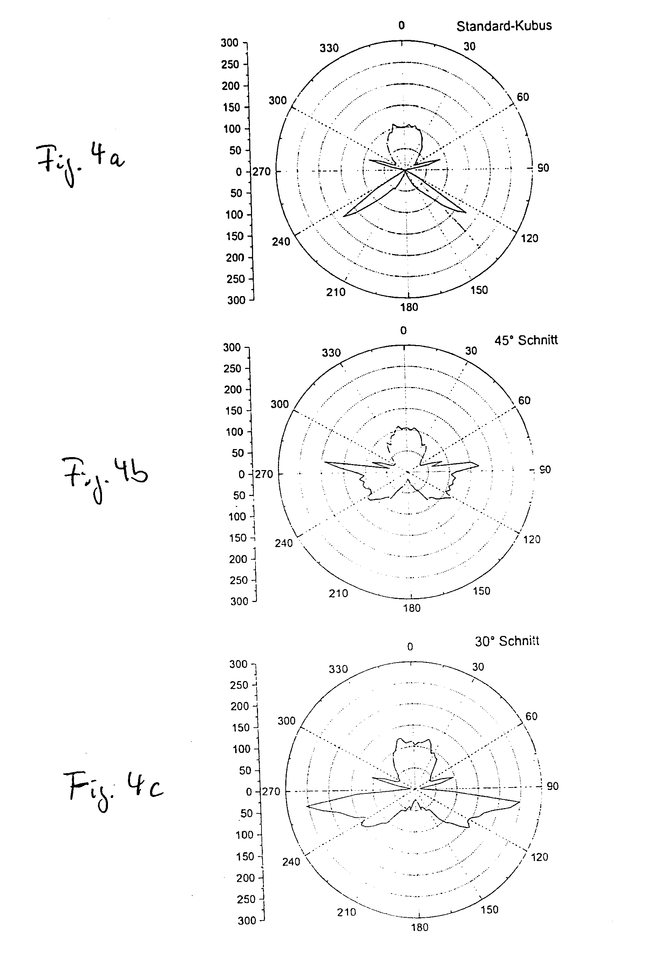

In den Figuren 4a bis 4c ist die Abstrahlcharakteristik eines herkömmlichen quaderförmigen Chips (Figur 4a; Kantenlänge/Epitaxieschichtenfolge ca. 260µm, Kantenlänge Substrat ca. 290µm und Substratdicke ca. 250µm) und die Abstrahlcharakteristika von zwei unterschiedlichen erfindungsgemäßen Halbleiterkörpern (Figuren 4b und 4c) gegenübergestellt. Figur 4b korrespondiert zu einem Halbleiterkörper gemäß Figur 1a mit Kantenlänge/Epitaxieschichtenfolge ca. 260µm, Kantenlänge/Substrat: oben ca. 290µm, unten ca. 190µm und Substratdicke ca. 250 µm, bei dem die ebenen schrägstehenden Substratseitenfläche 20a und die Mittelachse 50 einen Winkel von 45° einschließen und von der Substratoberseite einen Abstand von ca. 25µm aufweisen. Figur 4c korrespondiert zu einem Halbleiterkörper gemäß Figur 1a mit Kantenlänge/Epitaxieschichtenfolge ca. 260µm, Kantenlänge/Substrat: oben ca. 290µm, unten ca. 190µm und Substratdicke ca. 250 µm, bei dem die ebenen schrägstehenden Substratseitenfläche 20a und die Mittelachse 50 einen Winkel von 30° einschließen und von der Substratoberseite einen Abstand von ca. 25µm aufweisen. Alle Halbleiterkörper weisen identische Mehrschichtstrukturen 100 und identisches Substratmaterial (SiC) auf. Die Diagramme geben den Abstrahlwinkel in 360°-Darstellung sowie die Abstrahlintensität in die jeweiligen Richtungen anhand von konzentrischen Kreisen an.

Gemäß Figur 4a ist erkennbar, daß ein bekannter quaderförmiger Licht emittierender GaN-basierter Chip mit SiC-Substrat nach oben in Richtung 0° mit einem Öffnungswinkel von ca. 60° und im wesentlichen mit zwei weiteren schmalen Keulen in Richtung 125° und 235° jeweils mit einem Öffnungswinkel von ca. 15° steil nach hinten abstrahlt. Demgegenüber zeigt der erfindungsgemäße Halbleiterkörper gemäß Figur 4c, der dieselbe Mehrschichtstruktur 100 und ein SiC-Substrat 20 aufweist, eine gegenüber Figur 4a deutlich erhöhte Strahlintensität im Winkelbereich zwischen ca. 95° und ca. 130° und im Winkelbereich zwischen ca. 230° und ca. 265°. Darüberhinaus ist auch im Winkelbereich zwischen 30° und 330° eine Verbesserung deutlich ersichtlich. Der Chip strahlt somit über die schrägen Seitenflächen 20a nahezu waagerecht ab. Insgesamt ergibt sich mit einer Anordnung gemäß Figur 4c ein deutlich, d.h um 80% oder mehr verbessertes Lichtauskoppelverhalten im Vergleich zu einem Chip mit herkömmlicher Geometrie.

Der zu Figur 4b korrespondierende Halbleiterkörper weist zwar ebenfalls eine gegenüber einem herkömmlichen Halbleiterkörper verbesserte Auskoppelcharakteristik auf (man vergleiche mit Figur 4a), erreicht aber bei weitem nicht die Verbesserung des zu Figur 4c korrespondierenden Halbleiterkörpers.

Bei dem Diagramm von Figur 5 ist der Auskoppelwirkungsgrad in % in Abhängigkeit vom Winkel α der schrägstehenden Seitenflächen 20a zur senkrechten Mittelachse eines Halbleiterkörpers gemäß der Ausführungsform von Figur 1a mit einer Mehrschichtstruktur auf GaN-Basis (n_{GaN}=2.5) auf einem SiC-Fenstersubstrat (n_{SiC}=2.7) aufgetragen. Die Kantenlänge des Substrats 20 oberhalb der schrägstehenden Seitenflächen 20a ist konstant bei 290µm gehalten. Die Winkelabhängigkeit wurde für drei verschiedene Kantenlängen des Montagesockels ermittelt. Das heißt, das Verhältnis Fensterkantenlänge oben/Fensterkantenlänge unten wurde variiert. Die Kurve 501 mit den Dreiecken korrespondiert zu einer Fensterkantenlänge unten von 165µm, die Kurve 502 mit den Quadraten zu 190µm und die Kurve 503 mit den Rauten zu 215µm. Es ist in allen Fällen ersichtlich, daß die Auskoppeleffizienz bei α zwischen 20° und 30° am größten ist und daß sie sowohl bei sehr kleinen als auch bei sehr großen Winkeln α stark abnimmt.

Aufgrund des größeren Brechungsindex von SiC im Vergleich zu GaN wird Strahlung, die von der Mehrschichtstruktur in das Fenstersubstrat übertritt, zum Lot hin gebrochen. Dadurch wird ein Winkelbereich aus der Mehrschichtstruktur im Fenstersubstrat komprimiert. Durch das Anschrägen der Seitenflanken des Fenstersubstrats wird erreicht, dass dieser komprimierte Winkelbereich so weit wie möglich mit dem Auskoppelkegel der Seitenflanke überlappt.

Das Diagramm von Figur 5 wurde mittels einer Raytracing-Berechnung anhand eines dreidimensionalen Modells des Halbleiterchips ermittelt. In dieser Rechnung sind alle möglichen Abstrahlkanäle des Chips enthalten, die Oberfläche, die Mesakanten und die geraden Flanken des Substrats. Es ist eine Dominanz der rückwärtigen Abstrahlung über die Sägekanten festzustellen. Experimentelle Versuche mit verschiedenen Flankenwinkeln, die besonders bevorzugt mittels eines Sägeblattes mit Formrand erzeugt werden (siehe weiter unten), bestätigen diese Berechnung. Für ein 45°-Sägeblatt wurde gegenüber einem herkömmlichen quaderförmigen Chip eine Lichtsteigerung von 50%, für ein 30°-Sägeblatt wurde eine Lichtsteigerung von über 80% erzielt.

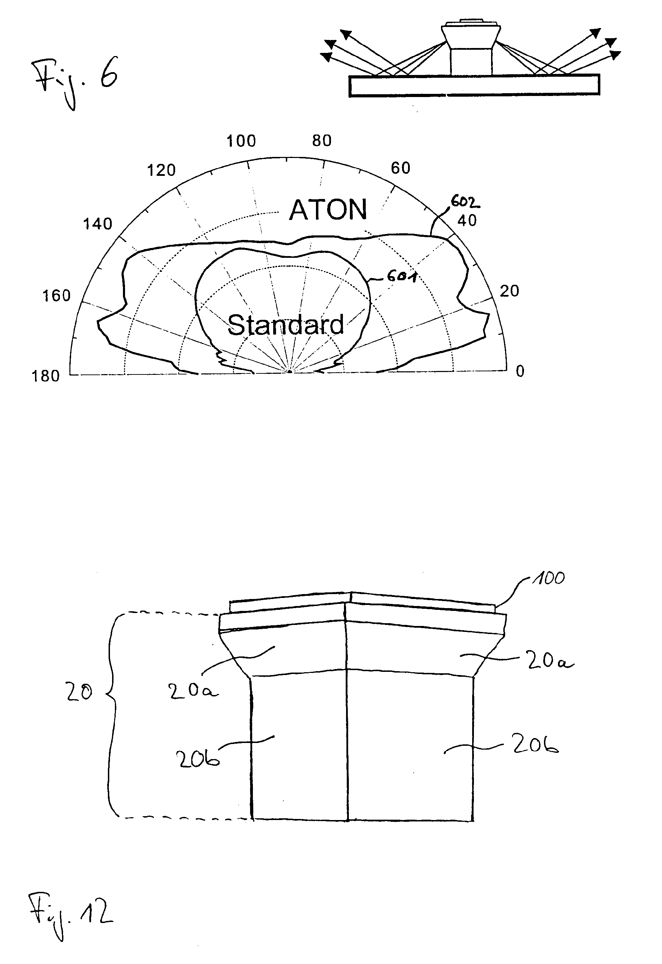

In Figur 6 ist die Fernfeldcharakteristik eines herkömmlichen quaderförmigen Chips der eines erfindungsgemäßen Chips gemäß Figur 1a mit α zwischen 20° und 30° (Grenzwerte eingeschlossen), jeweils montiert auf einer ebenen reflektierenden Fläche, gegenübergestellt. Die innere Kurve 601 korrespondiert zum herkömmlichen Chip und die äußere Kurve 602 korrespondiert zum erfindungsgemäßen Chip.

Für ein erfindungsgemäßes Halbleiterbauelement, das einen quadratischen lateralen Querschnitt aufweist, bei dem alle vier Seitenflanken der Fensterschicht 20 einen ebenen schrägstehenden ersten Seitenwandteil 20a aufweisen, liegt das Verhältnis von Kantenlänge der Mehrschichtstruktur 100 zu Kantenlänge des Montagesockels bevorzugt zwischen einschließlich 1,5 und einschließlich 2, besonders bevorzugt bei etwa 1,35.

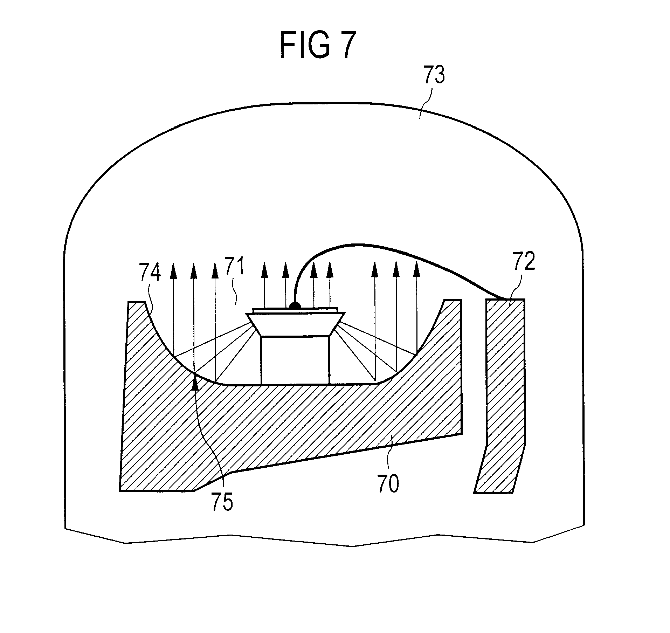

Bei dem optischen Bauelement gemäß Figur 7 ist vorgesehen, daß ein erfindungsgemäßer Halbleiterkörper beispielsweise nach Figur 1a in die Ausnehmung 71 eines Grundkörpers 70 montiert ist. Der Grundkörper 70 kann beispielsweise wie in Figur 7 dargestellt, ein elektrischer Anschluß-Leiterteil einer Radial-LED sein, der elektrisch mit dem Metallkontakt 40 des Halbleiterkörpers kontaktiert ist, während der Metallkontakt 30 über einen Bonddraht mit einem zweiten elektrischen Anschluß-Leiterteil 72 der LED verbunden ist. Die Gesamtanordnung ist mit einem transparenten Material 73 umhüllt.

Ebenso gut kann das erfindungsgemäße lichtemittierende Halbleiterbauelement in das Gehäuse bzw. den Grundkörper einer nach oben abstrahlenden oberflächenmontierbaren LED angeordnet sein. Auch dort ist ein Grundkörper gebildet, der eine Ausnehmung aufweist, in der das Halbleiterbauelement montiert wird.

Die Seitenwände 74 der Ausnehmung 71 des Grundkörpers 70 sind als Reflektor ausgebildet, was entweder durch die Wahl des Materials des Grundkörpers oder durch eine Beschichtung der Ausnehmung erfolgen kann. Der Reflektor ist zweckmäßig, um das gemäß Figur 6b seitwärts schräg nach unten abgestrahlte Licht nutzbar nach vorne in Richtung des Metallkontakts 30 des Halbleiterbauelements abzustrahlen. Die Form des Reflektors 74 ist dabei so gewählt, daß sich die gewünschte Abstrahlcharakteristik ergibt. Für stark nach oben bzw. nach vorn gerichtete Strahlung ist eine Reflektorform zweckmäßig, deren Seitenneigung nach außen hin zunimmt, beispielsweise in Form einer Halbparabel.

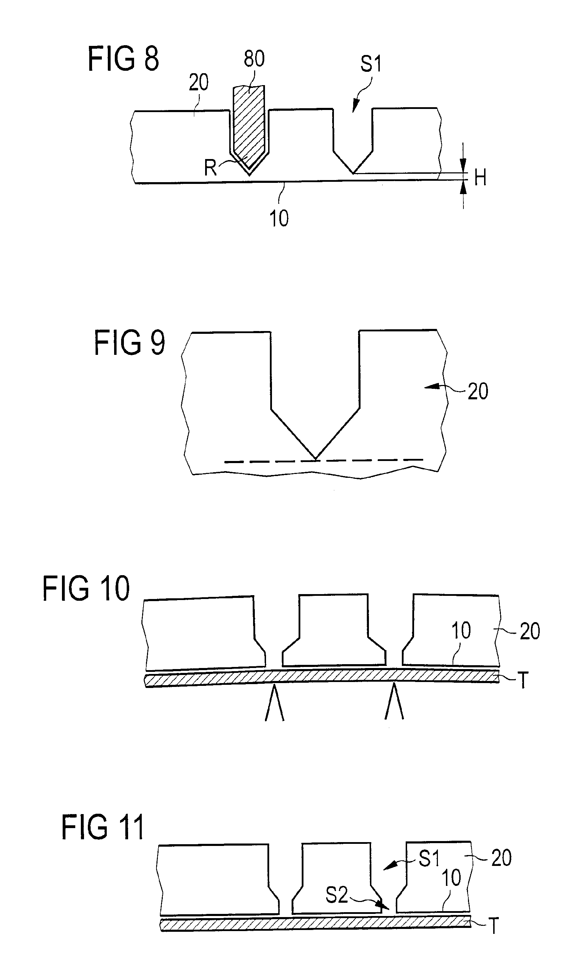

Gemäß den Figuren 8 bis 11 wird die Herstellung eines erfindungsgemäßen lichtemittierenden Halbleiterbauelements, genauer die gleichzeitige Herstellung einer Mehrzahl von Halbleiterbauelementen skizziert. In Figur 8 sind schematisch mit den Bezugszeichen gemäß Figur 1 die lichtemittierende Schicht 10 sowie das Fenster 20 gekennzeichnet. Im Ausführungsbeispiel ist die lichtemittierende Schicht dabei an Stellen vorgesehen, an denen das spätere lichtemittierende Bauelement erzeugt werden soll. Mit an sich bekannten Methoden wird dabei gemäß Figur 8 zunächst auf dem Substrat 20 die nicht näher dargestellte Mehrschichtstruktur mit den jeweiligen aktiven Schichten 10 erzeugt. Die Herstellungsmethoden umfassen dabei insbesondere Maskierungs- und Beschichtungstechniken, z. B. Epitaxieverfahren. Nach der Epitaxie wird die Epitaxieschichtenfolge bevorzugt mittels Maskieren und Ätzen in eine Mehrzahl von Mehrschichtstrukturen separiert.

Gemäß der Erfindung wird nach der Erzeugung der Mehrschichtstrukturen die Anordnung von der Rückseite, d.h. von der Fensterseite, mit einem Profilsägeblatt entlang der gegenüberliegenden Ätzgräben zwischen den Mehrschichtstrukturen der späteren Chips eingesägt, dessen Rand R eine vorgegebene Form aufweist. Im Ausführungsbeispiel ist der Rand v-förmig ausgebildet. Das Einsägen erfolgt nun so, daß das Substrat nicht nur mit der Spitze des v-förmigen Sägeblattes 80 angeritzt wird, sondern daß der Schnitt so tief ausgeführt wird, daß auch der blattförmige Teil des Sägeblattes in das Substrat einsägt. Es ergibt sich damit ein Sägeschnitt S1, der zunächst mit senkrechten Wänden in das Substrat hineingeht, um danach entsprechend der Randform R des Sägeblattes, in diesem Fall v-förmig zuzulaufen. Möglich ist auch ein runder oder anders geformter Profilrand.

Die nach dem Sägen zwischen der Einkerbung im Substrat und der lichtemittierenden Schicht verbleibende Resthöhe H beträgt typisch 10 µm bis 100 µm. Figur 9 zeigt noch einmal bezogen auf Figur 1, wie zwischen dem v-förmigen Einschnitt und der lichtemittierenden Schicht 10 der Winkel α gemäß Fig. 1 gebildet wird.

Nach dem Ansägen gemäß Figur 8 werden die Bauelemente, abhängig von der Resthöhe H, bevorzugt entweder durch ein Keilbrechverfahren gemäß Figur 10 oder durch einen zweiten Sägeschnitt vereinzelt. Dazu wird die eingeschnittene Anordnung gemäß Figur 8 auf einen Träger T aufgeklebt. Gemäß Figur 10 erfolgt dann von der freien Unterseite des Trägers ein Aufbrechen der Resthöhe H mit Hilfe eines Brechkeils. Gemäß Figur 11 ist es alternativ möglich, mit einem zweiten Sägeschnitt S2 den Wafer zu zerteilen, so daß die einzelnen Halbleiterbauelemente vereinzelt werden.

Die Auswahl der Randform R des Profilsägeblattes richtet sich nach den gewünschten Seitenoberflächen des Substrats und diese wiederum danach, wie eine maximale Lichtauskopplung erreicht werden kann. Abhängig von den Brechungsindices des Halbleitermaterials und der Umgebung bzw. des Substrats liegen typische Winkel α bei einem v-förmigen Sägeschnitt zwischen 10° und 70°.

Eine räumliche Darstellung eines bevorzugten erfindungsgemäßen Halbleiterbauelements mit SiC-Aufwachs- bzw. Fenstersubstrat und GaN-basierte Mehrschichtstruktur 100 ist in der Figur 12 dargestellt.

## Patentansprüche

1. Strahlungsemittierendes Halbleiterbauelement mit
- einer Mehrschichtstruktur (100), die eine strahlungsemittierende aktive Schicht (10) enthält,
- elektrischen Kontakten (30, 40) zur Stromeinprägung in die Mehrschichtstruktur (100), und
- einer strahlungsdurchlässigen Fensterschicht (20), die
- ausschließlich an der von einer Hauptabstrahlrichtung des Halbleiterbauelements abgewandten Seite der Mehrschichtstruktur (100) angeordnet ist,
- mindestens eine Seitenwand aufweist, die einen schräg zu einer senkrecht zur Mehrschichtenfolge stehenden Mittelachse des Halbleiterkörpers hin verlaufenden ersten Seitenwandteil (20a) aufweist, der gesehen von der Mehrschichtstruktur im weiteren Verlauf zur der von der Hauptabstrahlrichtung weg in einen zweiten Seitenwandteil (20b) übergeht, **dadurch gekennzeichnet, daß**
- der zweite Seitenwandteil (20b) senkrecht zur Mehrschichtstruktur, das heißt parallel zur Mittelachse verläuft, und
- der den zweiten Seitenwandteil (20b) umfassende Teil der Fensterschicht (20) einen Montagesockel für das Halbleiterbauelement bildet und
- der erste Seitenwandteil (20a) eine ebene schrägstehende Fläche ist, die mit der Mittelachse (50) einen Winkel (α) einschließt, der zwischen einschließlich 20° und einschließlich 40° liegt.

2. Halbleiterbauelement nach Anspruch 1,
bei dem die Fensterschicht (20) von einem Aufwachssubstrat gebildet ist.

3. Halbleiterbauelement nach einem der vorhergehenden Ansprüche, bei dem der Brechungsindex des Materials der Fensterschicht (20) größer als der Brechungsindex des Materials der Mehrschichtfolge (100), insbesondere der aktiven Schicht (10) ist.

4. Halbleiterbauelement nach einem der vorhergehenden Ansprüche, bei dem die Fensterschicht (20) aus Siliciumcarbid besteht oder auf SiC basiert und die Mehrschichtfolge aus Nitrid-basierten Halbleitermaterialien, insbesondere aus GaN-basierten Halbleitermaterialien gefertigt ist.

5. Halbleiterbauelement nach einem der vorhergehenden Ansprüche, bei dem alle Seitenflanken der Fensterschicht (20) einen ersten Seitenwandteil (20a) und eine zweiten Seitenwandteil (20b) aufweisen.

6. Halbleiterbauelement nach Anspruch 4 und 5, das einen quadratischen lateralen Querschnitt aufweist, bei dem alle vier Seitenflanken der Fensterschicht (20) einen ebenen schrägstehenden ersten Seitenwandteil (20a) aufweisen und bei dem das Verhältnis von Kantenlänge der Mehrschichtstruktur (100) zu Kantenlänge des Montagesockels zwischen einschließlich 1,5 und einschließlich 2, besonders bevorzugt bei etwa 1,35 liegt.

7. Halbleiterbauelement nach einem der vorhergehenden Ansprüche, bei dem mindestens der erste Seitenwandteil (20a) aufgerauht ist.

8. Strahlungsemittierendes optisches Bauelement mit einem strahlungsemittierenden Halbleiterbauelement nach einem der Ansprüche 1 bis 7, das eine Reflektorwanne (410) mit schrägstehenden oder parabelartigen Seitenwänden (350) aufweist, in der das Halbleiterbauelement derart montiert ist, dass die Fensterschicht (20) zum Reflektorwannenboden (430) hin gerichtet ist.

9. Strahlungsemittierendes optisches Bauelement nach dem vorherigen Anspruch, bei dem Seitenwände der Reflektorwanne mit reflexionssteigerndem Material beschichtet sind.

10. Strahlungsemittierendes optisches Bauelement nach einem der beiden vorherigen Ansprüche, bei dem die Seitenwände der Reflektorwanne so ausgebildet sind, daß die vom Halbleiterbauelement nach rückwärts ausgesandte Strahlung von den schrägen Seitenwänden weitestgehend in ein und derselben Richtung zur aktiven Schicht nach oben reflektiert wird.

11. Verfahren zur Herstellung eines strahlungsemittierenden Halbleiterbauelements nach einem der Patentansprüche 1 bis 7, mit folgenden Schritten:
- Herstellen einer Vielzahl von nebeneinander angeordneten der Mehrschichtstrukturen (100) auf einem großflächigen Substratwafer (20),
- Einsägen des Substratwafers (20) von der Substratrückseite her mit einem Sägeblatt (80) mit Formrand (R), der die Negativform der vorgesehenen Form der ersten Seitenwandteile (20a) aufweist, bis zu einer vorgegebenen Tiefe, in der der blattförmige Teil des Sägeblattes in das Substrat sägt,
- Vereinzeln des Wafers entlang der Sägeschnitte und
- Weiterverarbeiten des vereinzelten Bauelements.

12. Verfahren nach dem vorherigen Anspruch, bei dem das Vereinzeln durch ein Brechverfahren oder einen zweiten Sägeschnitt erfolgt.

13. Verfahren nach einem der beiden vorherigen Ansprüche, bei dem Metallkontakte vor dem Einsägen von der Substratrückseite her auf den freien Oberflächen des Substrats bzw. der Mehrschichtstruktur hergestellt werden.

14. Verfahren nach einem der Ansprüche 11 bis 13,
bei dem das Einsägen mit einem Sägeblatt mit v-förmigem Rand erfolgt.

## Claims

1. Radiation-emitting semiconductor component comprising
- a multilayer structure (100) containing a radiation-emitting active layer (10),
- electrical contacts (30, 40) for inputting current into the multilayer structure (100), and
- a radiation-transmissive window layer (20), which
- is arranged exclusively at that side of the multilayer structure (100) which faces away from a main emission direction of the semiconductor component,
- has at least one sidewall which has a first sidewall part (20a), which runs obliquely toward a centre axis of the semiconductor body, said centre axis being perpendicular to the multilayer sequence, and which, as viewed from the multilayer structure in the further course away from the main emission direction, undergoes transition to a second sidewall part (20b), **characterized in that**
- the second sidewall part (20b) runs perpendicularly to the multilayer structure, that is to say parallel to the centre axis, and
- that part of the window layer (20) which comprises the second sidewall part (20b) forms a mounting base for the semiconductor component, and
- the first sidewall part (20a) is a planar oblique area which forms an angle (α) with the centre axis (50), said angle being between 20° and 40° inclusive.

2. Semiconductor component according to Claim 1,
wherein the window layer (20) is formed by a growth substrate.

3. Semiconductor component according to either of the preceding claims, wherein the refractive index of the material of the window layer (20) is greater than the refractive index of the material of the multilayer sequence (100), in particular of the active layer (10).

4. Semiconductor component according to any of the preceding claims, wherein the window layer (20) consists of silicon carbide or is based on SiC and the multilayer sequence is produced from nitride-based semiconductor materials, in particular from GaN-based semiconductor materials.

5. Semiconductor component according to any of the preceding claims, wherein all side flanks of the window layer (20) have a first sidewall part (20a) and a second sidewall part (20b).

6. Semiconductor component according to Claims 4 and 5, which has a square lateral cross section, wherein all four side flanks of the window layer (20) have a planar oblique first sidewall part (20a) and wherein the ratio of the edge length of the multilayer structure (100) to the edge length of the mounting base is between 1.5 and 2 inclusive, particularly preferably approximately 1.35.

7. Semiconductor component according to any of the preceding claims, wherein at least the first sidewall part (20a) is roughened.

8. Radiation-emitting optical component comprising a radiation-emitting semiconductor component according to any of Claims 1 to 7, which comprises a reflector trough (410) having oblique or parabola-like sidewalls (350), in which reflector trough the semiconductor component is mounted in such a way that the window layer (20) is directed toward the reflector trough bottom (430).

9. Radiation-emitting optical component according to the preceding claim, wherein sidewalls of the reflector trough are coated with reflection-increasing material.

10. Radiation-emitting optical component according to either of the two preceding claims, wherein the sidewalls of the reflector trough are embodied such that the radiation emitted rearwards by the semiconductor component is reflected upwards by the oblique sidewalls to the greatest possible extent in one and the same direction with respect to the active layer.

11. Method for producing a radiation-emitting semiconductor component according to any of Patent Claims 1 to 7, comprising the following steps:
- producing a multiplicity of the multilayer structures (100) arranged alongside one another on a large-area substrate wafer (20),
- sawing into the substrate wafer (20) from the substrate rear side by means of a saw blade (80) having a shaped edge (R), which has the negative shape of the envisaged shape of the first sidewall parts (20a), as far as a predefined depth at which the blade-shaped part of the saw blade saws into the substrate,
- singulating the wafer along the saw cuts, and
- subjecting the singulated component to further processing.

12. Method according to the preceding claim, wherein the singulating is carried out by means of a breaking method or a second saw cut.

13. Method according to either of the two preceding claims, wherein metal contacts are produced on the free surfaces of the substrate and the multilayer structure, respectively before the process of sawing in from the substrate rear side.

14. Method according to any of Claims 11 to 13,
wherein the sawing in is carried out by means of a saw blade having a v-shaped edge.

## Revendications

1. Composant à semi-conducteurs émettant un rayonnement, avec
- une structure à plusieurs couches (100), qui contient une couche active émettant un rayonnement (10),
- des contacts électriques (30, 40) pour appliquer un courant dans la structure à plusieurs couches (100), et
- une couche de fenêtre (20) perméable au rayonnement, qui
- est disposée exclusivement sur le côté de la structure à plusieurs couches (100) situé à l'opposé d'une direction de rayonnement principale du composant à semi-conducteurs,
- présente au moins une paroi latérale, qui présente une première partie de paroi latérale (20a) s'étendant en oblique par rapport à un axe central du corps semi-conducteur orienté perpendiculairement à la suite de plusieurs couches, la première partie de paroi latérale (20a) qui, vue de la structure à plusieurs couches, se transforme dans son tracé ultérieur s'éloignant de la direction de rayonnement principale en une deuxième partie de paroi latérale (20b), **caractérisé en ce que**
- la deuxième partie de paroi latérale (20b) s'étend perpendiculairement à la structure à plusieurs couches, c'est-à-dire parallèlement à l'axe central, et
- la partie de la couche de fenêtre (20) comprenant la deuxième partie de paroi latérale (20b) forme un socle de montage pour le composant à semi-conducteurs, et
- la première partie de paroi latérale (20a) est une face plane disposée en oblique, qui forme avec l'axe central (50) un angle (α) qui se situe entre 20° inclus et 40° inclus.

2. Composant à semi-conducteurs selon la revendication 1, dans lequel la couche de fenêtre (20) est formée par un substrat de croissance.

3. Composant à semi-conducteurs selon l'une quelconque des revendications précédentes, dans lequel l'indice de réfraction du matériau de la couche de fenêtre (20) est plus grand que l'indice de réfraction du matériau de la suite de plusieurs couches (100), en particulier de la couche active (10).

4. Composant à semi-conducteurs selon l'une quelconque des revendications précédentes, dans lequel la couche de fenêtre (20) se compose de carbure de silicium ou est à base de SiC et la suite de plusieurs couches est fabriquée en matériaux semi-conducteurs à base de nitrure, en particulier en matériaux semi-conducteurs à base de GaN.

5. Composant à semi-conducteurs selon l'une quelconque des revendications précédentes, dans lequel tous les flancs latéraux de la couche de fenêtre (20) présentent une première partie de paroi latérale (20a) et une deuxième partie de paroi latérale (20b).

6. Composant à semi-conducteurs selon la revendication 4 et 5, qui présente une section transversale latérale carrée, dans lequel les quatre flancs latéraux de la couche de fenêtre (20) présentent tous une première partie de paroi latérale (20a) plane disposée en oblique et dans lequel le rapport de la longueur des côtés de la structure à plusieurs couches (100) à la longueur des côtés du socle de montage se situe entre 1,5 inclus et 2 inclus, en particulier de préférence à environ 1,35.

7. Composant à semi-conducteurs selon l'une quelconque des revendications précédentes, dans lequel au moins la première partie de paroi latérale (20a) est dépolie.

8. Composant optique émettant un rayonnement avec un composant à semi-conducteurs émettant un rayonnement selon l'une quelconque des revendications 1 à 7, qui présente une cuvette de réflecteur (410) avec des parois latérales (350) disposées en oblique ou de forme parabolique, dans laquelle le composant à semi-conducteurs est monté de telle manière que la couche de fenêtre (20) soit orientée vers le fond (430) de la cuvette de réflecteur.

9. Composant optique émettant un rayonnement selon la revendication précédente, dans lequel des parois latérales de la cuvette de réflecteur sont revêtues d'un matériau augmentant la réflexion.

10. Composant optique émettant un rayonnement selon l'une quelconque des deux revendications précédentes, dans lequel les parois latérales de la cuvette de réflecteur sont configurées de telle manière que le rayonnement émis en arrière par le composant à semi-conducteurs soit réfléchi vers le haut par les parois latérales obliques très largement dans une seule et même direction vers la couche active.

11. Procédé de production d'un composant à semi-conducteurs émettant un rayonnement selon l'une quelconque des revendications 1 à 7, présentant les étapes suivantes:
- produire une multiplicité de structures à plusieurs couches (100) disposées les unes à côté des autres sur une galette de substrat de grande étendue (20),
- entailler la galette de substrat (20) à partir du côté arrière du substrat avec une lame de scie (80) dotée d'un bord profilé (R), qui présente la forme négative de la forme prévue des premières parties de paroi latérale (20a), jusqu'à une profondeur prédéterminée, à laquelle la partie de la lame de scie en forme de lame scie dans le substrat;
- détacher la galette le long des traits de scie, et
- traiter ensuite le composant détaché.

12. Procédé selon la revendication précédente, dans lequel le détachement est effectué par un procédé de cassure ou une deuxième entaille de sciage.

13. Procédé selon l'une des deux revendications précédentes, dans lequel des contacts métalliques sont réalisés sur les surfaces libres du substrat ou de la structure à plusieurs couches avant l'entaillage à partir du côté arrière du substrat.

14. Procédé selon l'une quelconque des revendications 11 à 13, dans lequel l'entaillage est effectué avec une lame de scie dotée d'un bord en forme de V.
